# EUROPEAN PATENT APPLICATION

(11) **EP 2 911 487 A1**
(43) Date of publication of application: **26.08.2015**
(21) Application number: 14156171.2
(22) Date of filing: 21.02.2014
(51) Int. Cl.: H05K 1/18, H05K 1/02

(54) **Circuit board mounting arrangement**

(71) Applicant: Autoliv Development AB, 447 83 Vårgårda (SE)
(72) Inventor: Caclard, Laurent, 27440 Touffreville (FR); Aubertin, Philippe, 95520 Osny (FR)
(74) Representative: Sandstedt, Jonas Sven James

(57) **Abstract**

The present invention relates to a circuit board (2) comprising at least one electrical connection arrangement (12, 13; 14, 15) that is arranged to be electrically connected to a corresponding electrical component (4) when said electrical component (4) is mounted to the circuit board (2). The circuit board (2) comprises at least one aperture (11, 11', 11''), where, for at least one of said electrical components (4), a corresponding aperture (11, 11', 11") is arranged to receive said electrical component (4). Then, a part of the electrical component (4) rests in the aperture (11, 11', 11'') when the electrical component (4) is mounted to the circuit board (2).

## Description

### DESCRIPTION OF THE INVENTION

The present invention relates to a circuit board comprising at least one electrical connection arrangement, of which at least one electrical connection arrangement is arranged to be electrically connected to a corresponding electrical component when said electrical component is mounted to the circuit board.

In many fields of electronics, printed circuit boards (PCB:s) are used. For instance, in the control of electrical systems on board a motor vehicle, it is desirable to provide a sealed non-conductive (e.g. plastic) housing containing a PCB, onto which are mounted several electrical components. An electrical unit of this type is disclosed in US 6163460.

In many cases, one of the electrical components that must be mounted to the PCB is at least one large, relatively heavy capacitor, which for example serves as a power reserve. While most of the electronic components are surface-mounted on the PCB, it is preferred not to attach a bulky capacitor to the PCB directly, since the weight of the capacitor is likely to break or distort the substrate or electrically conducting tracks of the PCB under certain conditions. It has therefore been proposed to attach large components such as capacitors to an interior surface of the housing of the unit, so that the weight of the component places no mechanical stress on the PCB itself, and to connect the component electrically to the PCB by one or more wires, cables or similar.

However, when assembling a unit of this type, it is preferred not to carry out such soldering operations, since they would be undesirable due to cost and efficiency.

In WO 2009/010704 it is descried how intermediate electrical connectors in holders are positioned such that conductive communication is provided between the PCB and conductive contact pins of a component, such as a relatively large and heavy capacitor attached to a housing of an electronic unit. The electrical connectors are press-fitted into the PCB in order to achieve the desired stability and electrical contact.

However, the need for press-fitting requires special electrical connectors, and in some situations it is desired to have other types of connections to the PCB while maintaining the desired stability. There may also be a need for further alignment. There is also a need for a housing to hold the capacitor in place.

There is thus a need for a PCB, or circuit board, to which an electrical component can be mounted in a more rigid and less complicated way than presented in prior art. It is therefore an object of the present invention to provide such a circuit board.

The object above is achieved by means of a circuit board comprising at least one electrical connection arrangement, of which at least one electrical connection arrangement is arranged to be electrically connected to a corresponding electrical component when said electrical component is mounted to the circuit board. The circuit board comprises at least one aperture, where, for at least one of said electrical components, a corresponding aperture is arranged to receive said electrical component such that a part of the electrical component rests in the aperture when the electrical component is mounted to the circuit board.

According to an example, said electrical connection arrangement comprises at least one solder pad (and/or at least one mounting aperture.

According to another example, the circuit board is arranged to be mounted to a housing. The housing may comprise a cradle arrangement. The cradle arrangement is arranged to engage the electrical component when the housing is mounted to the circuit board, then applying a retaining pressure on the electrical component. Then, the electrical component is pressed into the aperture by the cradle arrangement.

According to another example, the cradle arrangement comprises at least one holding member with a cut-out that is arranged to at least partly engage the electrical component when the housing is mounted to the circuit board.

According to another example, the cradle arrangement comprises at least one resilient member. Each resilient member is arranged to engage the electrical component and to apply a resilient pressure on the electrical component when the housing is mounted to the circuit board.

According to another example, the aperture comprises chamfered edges such that there is an inclination where the circuit board is arranged to contact the electrical component.

Further examples are apparent in the dependent claims.

A number of advantages are obtained by means of the present invention, mainly a circuit board is provided, to which circuit board an electrical component can be mounted in a more rigid and less complicated way than presented in prior art.

### BRIEF DESCRIPTION OF THE DRAWINGS

The present invention will now be described more in detail with reference to the appended drawings, where:
- Figure 1: shows a schematic perspective view of an electronic unit;
- Figure 2: shows a schematic perspective view of a capacitor about to be mounted to a first example of a PCB according to the present invention;
- Figure 3: shows a schematic perspective view of a capacitor mounted to the PCB in Figure 2;
- Figure 4: shows a schematic perspective view of a capacitor mounted to a second example of a PCB according to the present invention;
- Figure 5: shows a schematic bottom view of a first example of a housing;
- Figure 6: shows a schematic cut-open side view of the housing in Figure 5 mounted to a PCB;
- Figure 7: shows a schematic cut-open side view of a second example of a housing mounted to a PCB;
- Figure 8: shows an enlarged cut-open side view of a capacitor about to be mounted to a third example of PCB according to the present invention;
- Figure 9: shows a schematic perspective view of a capacitor about to be mounted to the PCB of Figure 2 with a resilient intermediate member attached to the aperture;
- Figure 10: shows a top view of a PCB of Figure 2 where the resilient intermediate member is an EMC frame; and
- Figure 11: shows a cut-open side view of an alternative mounting of a capacitor to the PCB of Figure 2.

### DETAILED DESCRIPTION

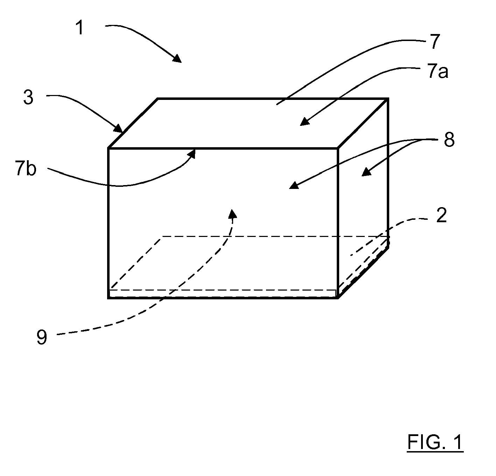

With reference to Figure 1, an electronic unit 1 is shown, the electronic unit 1 comprising a printed circuit board 2 (PCB) and a housing 3. The electronic unit 1 may be a part of a control system in a vehicle and comprises electronic components and connectors, although these are not shown in this simplified view. The PCB 2 is of an ordinary kind, comprising conductive tracks and component connections, not shown in this simplified view. The PCB 2 may have one or several conductive layers, where some layers may comprise conductive tracks and some layers may comprise ground planes.

The housing comprises a top lid 7 and connecting walls 8 running circumferentially around the lid 7, defining an inner space 9. The top lid 7 thus has an outer side 7a and an inner side 7b, the inner side 7b facing the inner space 9. In a first example of the housing 3, the inner space 9 does not comprise any additional items. Additional items in the inner space 9 will be described later for further examples of the housing.

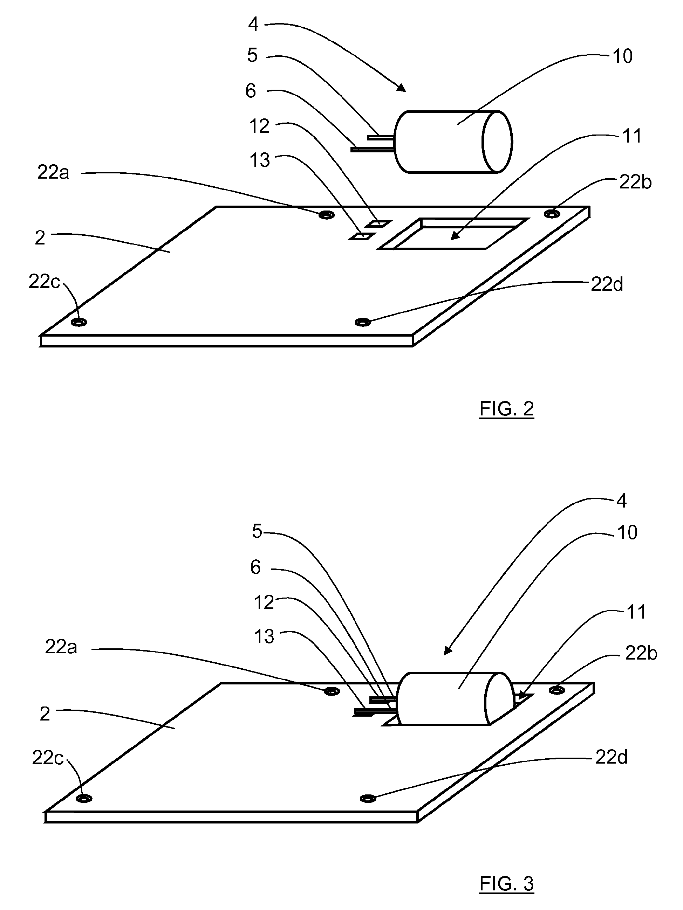

Figure 2 shows a perspective view of a first example of the PCB and the capacitor 4 without the housing and any other components, the capacitor 4 not yet having been mounted. The capacitor 4 of a type which incorporates a relatively large, substantially cylindrical body 10 and has two electrically conducting contact pins 5, 6 protruding therefrom, each of the contact pins 5, 6 comprising a metal lead having a round or rectangular cross-section.

According to the present invention, the PCB 2 comprises an aperture 11 that is arranged to partly receive the capacitor 4, such that a part of the capacitor 4 rests in the aperture 11 when mounted to the PCB 2.

Figure 3 corresponds to Figure 2, but here the capacitor 4 has been mounted to the side of PCB 2 that is arragned to face the housing 3. With reference to Figure 2 and Figure 3, the aperture 11 is in this example adapted such that the capacitor's contact pins 5, 6 come to lie on the PCB 2, allowing an easy mounting by means of soldering of the contact pins 5, 6 to corresponding solder pads 12, 13 on the PCB.

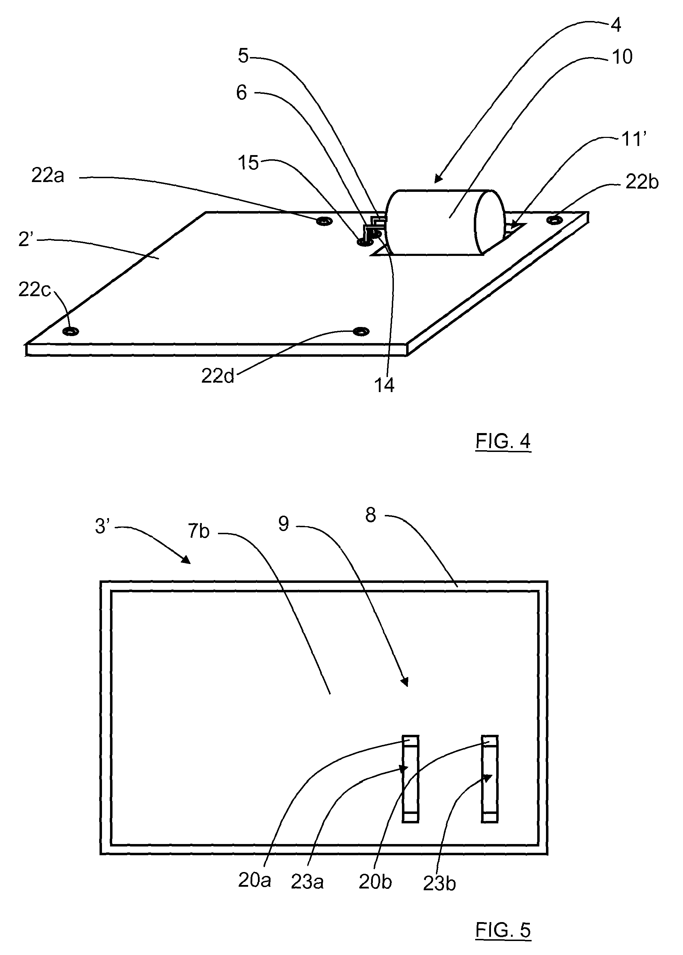

However, as shown in Figure 4, showing a second example of the PCB 2', the aperture 11' may have a standard shape, arranged to accommodate a plurality of capacitor shapes. The only requirement is that the width of the aperture 11' falls below the capacitor's diameter, such that the capacitor 4 always is retained in the aperture 11' when mounted. The contact pins 5, 6 are here bent such that they fit into corresponding mounting apertures 14, 15 in the PCB 2.

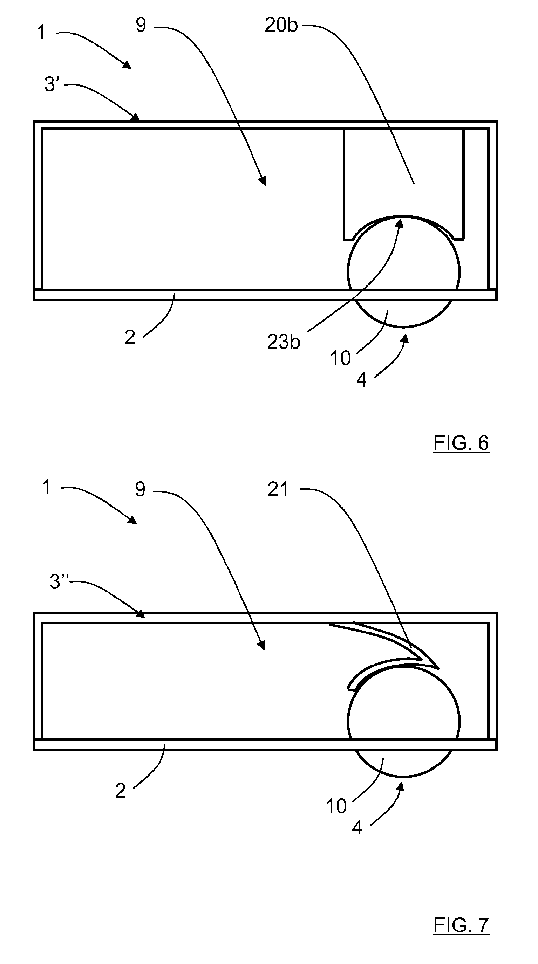

Figure 5 shows a bottom view of a second example of the housing 3', into the inner space 9, and Figure 6 shows a cut-open side view of the PCB 2 with the capacitor 4 mounted. With reference to Figure 5 and Figure 6, the housing 3' comprises a cradle arrangement 20a, 20b on the inner side of the top lid. When the capacitor 4 is mounted, the cradle arrangement 20a, 20b is arranged to engage the capacitor 4 when the housing 3' is mounted to the PCB 2, applying a retaining pressure on the capacitor 4 such that the capacitor 4 is pressed into the aperture 11 by the cradle arrangement 20a, 20b.

The cradle arrangement comprises two holding members 20a, 20b with cut-outs 23a, 23b at least roughly corresponding to the curvature of a capacitor 4. The cut-outs 23a, 23b are arranged to at least partly engage the capacitor 4 when the housing 3' is mounted to the PCB 2.

Another example of a cradle arrangement is shown in a third example of the housing 3" in Figure 7. Figure 7 shows a cut-open side view of the PCB 2 with the capacitor 4 mounted, where the housing 3" comprises one or more resilient members 21, each resilient member 21 being arranged to engage the capacitor 4 and to apply a resilient pressure on the capacitor 4 when the housing 3" is mounted to the PCB 2.

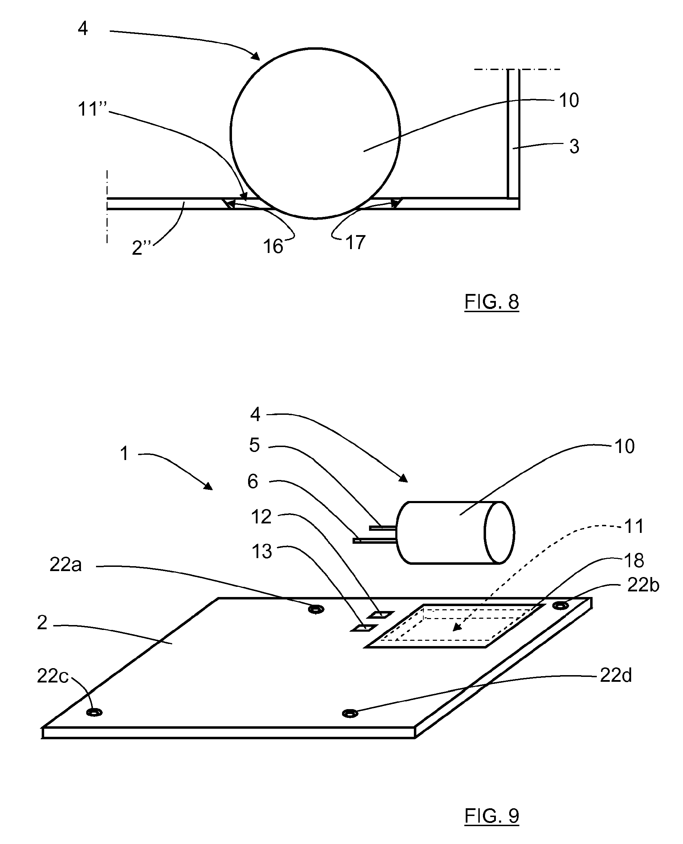

With reference to Figure 8, showing an enlarged cut-open view of a third example of the PCB 2", a capacitor 4 is about to be mounted in the aperture 11". In order to spare the mounted capacitor 4 from possible damage from the PCB 2", the aperture edges are chamfered 16, 17 such that there is an inclination where the PCB 2 is arranged to contact the capacitor 4.

With reference to Figure 9, showing a view that mainly corresponds to Figure 2, another way to alleviate the capacitor 4 from stresses is disclosed. Here, a resilient intermediate member 18 is attached to the PCB 2, either alone or in combination with the chamfers discussed above. The resilient intermediate member 18 may be in the form of a coherent surface, covering at least a part of the aperture 11, such as a rubber mat or similar. In order to obtain a good EMC (Electromagnetic compatibility) shielding, the resilient intermediate member 18 may be electrically conducting.

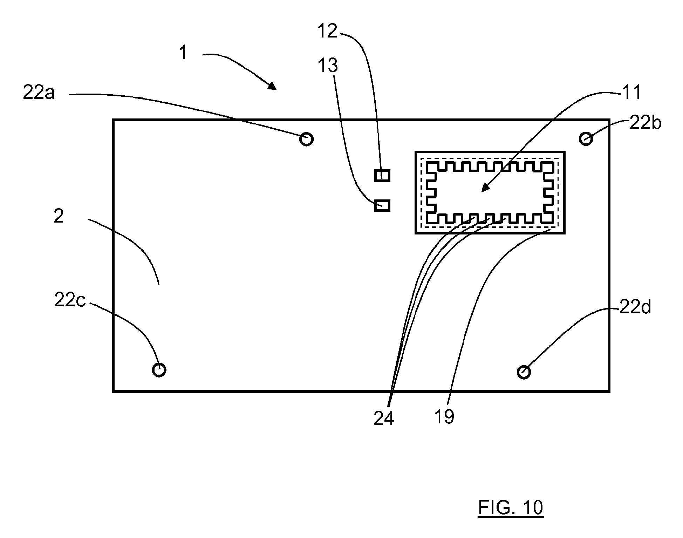

With reference to Figure 10, showing a top view that mainly corresponds to the configuration of the PCB 2 of Figure 2 without the capacitor, the resilient intermediate member is in the form of an EMC shielding metallic foil frame 19 with resilient fingers 24 (only a few indicated in Figure 10) that are arranged to the engage the capacitor 4.

In order to obtain a rigid retaining function for the capacitor, the aperture may be placed where there is other mechanical support for the PCB, for example at an edge or a corner. As shown in Figure 2, Figure 3, Figure 4, Figure 9 and Figure 10, the PCB comprises a plurality of mounting apertures 22a, 22b, 22c, 22d for screw mounting of the PCB 2 to any suitable wall or frame structure. Two of the mounting apertures 22a, 22b are placed in the vicinity of the aperture 11 that is adapted to receive the capacitor 4, and thus there will be an enhanced support for the PCB there.

The housing 3, 3', 3" is formed from a sturdy, insulating material such as a plastics material. The housing may further be insulated with respect to EMC, for example by means of having a conducting material mixed in the housing material, or by having a thin metallic layer deposited on one side.

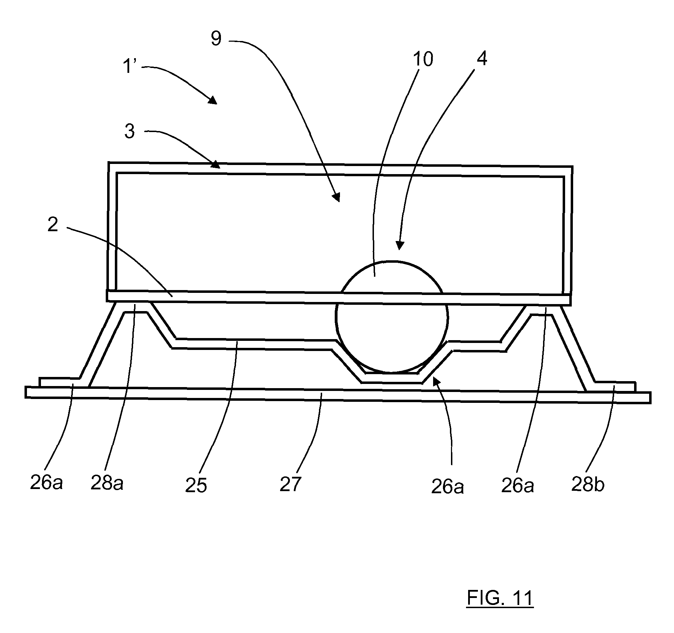

With reference to Figure 11 that shows a cut-open side view of an alternative electronic unit 1', the capacitor 4 is mounted to the side of the PCB 2 that faces away from the mounted housing 3. In this example, there is no need for a cradle arrangement in the housing 3 in order to obtain an enhanced stability of the mounted capacitor 4. Instead, the capacitor 4 is pressed against the aperture in the PCB 2 by means of a mounting plate 25 that has a shape with lower mounting flanges 26a, 26b for mounting to an attachment surface 27, upper mounting flanges 28a, 28b for mounting to the PCB 2 and a through part 29 that is arranged to receive a part of the capacitor 4 that faces away from the aperture. The mounting plate 25 is for example mounted to the attachment surface 27 and the PCB 2 by means of screws (not shown) via the corresponding mounting flanges 26a, 26b; 28a, 28b.

In this example, the chamfered edges 16, 17 and/or any resilient intermediate member 18, 19 are positioned adapted for a capacitor 4 that is mounted from the side of the PCB 2 that faces away from the mounted housing 3.

This example is also conceivable for a PCB without any housing, the capacitor 4 generally being mounted to the side of the PCB 2 that is arranged to face an attachment surface 27 to which the PCB 2 is intended to be attached.

The present invention is not limited to the above, but may vary freely within the scope of the appended claims. For example, the housing 3 may comprise any suitable cradle arrangement or similar, comprising any number and type of holders. The capacitor 4 may even be glued or stuck to the housing 1 in any other convenient way.

The housing and the PCB may have any suitable shape, such as round, oval and/or with several corners.

The PCB may be any sort of suitable circuit board, being made from for example glass fiber or any other suitable material.

The capacitor 4 may generally be any type of electric component having at least one contact pin 5, 6 that is intended to be electrically connected to the PCB 2. A number of electrical components may be attached to the housing and mounted to the PCB in the same way as the capacitor 4 shown in the examples above, the capacitor generally constituting a first electrical component. The PCB 2 may then comprise one or several apertures according to the present invention, depending on the number of large components that are intended to be mounted to the PCB. Corresponding cradle arrangements may be present for one or several such components in the housing 3.

The capacitor may be electrically connected by means of, for example, solder paste or electrically conducting glue.

The piece of the PCB that is cut out for forming the aperture 11, may be used as a separate circuit board part.

The solder pads 12, 13 or mounting apertures 14, 15 may be positioned at different distances from the aperture 11 in order to more easily mount the contact pins with the correct polarity. The solder pad or mounting aperture that is closest to the aperture 11 may for example be intended for mounting of the capacitor's positive contact pin.

For reasons of clarity, only the capacitor and its connections have been shown at the PCB 2. Other items on the PCB 2 such as for example electronic components, connectors, conductive tracks and component connections are not shown, although they of course are present. How such a PCB 2 is configured should be obvious to a person skilled in the art.

There might be a relatively tight fit between the capacitor and the aperture's edges in order to improve EMC. Electrically conducting glue or similar may be used to seal the aperture electromagnetically.

The PCB 2 is generally constituted by a circuit board.

The solder pads 12, 13 or mounting apertures 14, 15 constitute an electrical connection arrangement.

The different examples of PCB:s 2, 2', 2", housings 3, 3', 3" and electronic units 1' may be combined in any suitable way. Other types of PCB:s, housings and electronic units are of course conceivable, all embodiments shown and discussed only being examples.

The present invention relates to the PCB, where an aperture 11, 11' is formed in the PCB 2. The aperture 11 ,11' is arranged to receive the capacitor 4 such that a part of the capacitor 4 rests in the aperture 11, 11' when the capacitor 4 is mounted to the circuit board 2. The PCB 2 may for example be used in an electronic unit 1 with a housing 3 as discussed.

The PCB may be used in many other applications, for example in a circuit board slot among a row of PCB:s, with or without the aperture according to the present invention, and in a circuit board holding and connection arrangement. The PCB may be used in any suitable electronic or electric application.

## Claims

1. A circuit board (2, 2', 2") comprising at least one electrical connection arrangement (12, 13; 14, 15), at least one electrical connection arrangement (12, 13; 14, 15) being arranged to be electrically connected to a corresponding electrical component (4) when said electrical component (4) is mounted to the circuit board (2, 2', 2"), **characterized in that** the circuit board (2, 2', 2") comprises at least one aperture (11, 11', 11"), where, for at least one of said electrical components (4), a corresponding aperture (11, 11', 11") is arranged to receive said electrical component (4) such that a part of the electrical component (4) rests in the aperture (11, 11', 11") when the electrical component (4) is mounted to the circuit board (2, 2', 2").

2. A circuit board (2, 2') according to claim 1, **characterized in that** said electrical connection arrangement (12, 13; 14, 15) comprises at least one solder pad (12, 13) and/or at least one mounting aperture (14, 15).

3. A circuit board (2) according to any one of the claims 1 or 2, **characterized in that** a housing (3, 3', 3") is arranged to be mounted to the circuit board (2).

4. A circuit board (2) according to claim 3, **characterized in that** the housing (3', 3") comprises a cradle arrangement (20 a, 20b; 21) that is arranged to engage the electrical component (4) when the housing (3', 3") is mounted to the circuit board (2), then applying a retaining pressure on the electrical component (4) such that the electrical component (4) is pressed into the aperture (11, 11', 11") by the cradle arrangement (20a, 20b; 21).

5. A circuit board (2) according to claim 4, **characterized in that** the cradle arrangement comprises at least one holding member (20a, 20b) with a corresponding cut-out (23a, 23b) that is arranged to at least partly engage the electrical component (4) when the housing (3') is mounted to the circuit board (2).

6. A circuit board (2) according to claim 4, **characterized in that** the cradle arrangement comprises at least one resilient member (21), each resilient member (21) being arranged to engage the electrical component (4) and to apply a resilient pressure on the electrical component (4) when the housing (3") is mounted to the circuit board (2).

7. A circuit board (2) according to any one of the previous claims, **characterized in that** the aperture (11") comprises chamfered edges (16, 17) such that there is an inclination where the circuit board (2") is arranged to contact the electrical component (4).

8. A circuit board (2) according to any one of the previous claims, **characterized in that** a resilient intermediate member (18) is attached to the circuit board (2), where the resilient intermediate member (18) is in the form of a coherent surface, covering at least a part of the aperture (11).

9. A circuit board (2) according to claim 8, **characterized in that** resilient intermediate member is in the form of an EMC, Electromagnetic compatibility, shielding metallic foil frame (19) with resilient fingers (24) that are arranged to the engage the electrical component (4) when the electrical component (4) is mounted to the circuit board (2).

10. A circuit board (2) according to any one of the previous claims, **characterized in that** the electrical component (4) is arranged to be mounted to the side of the PCB (2) that is arranged to face an attachment surface (27) to which the PCB (2) is intended to be attached via a mounting plate (25), where the mounting plate (25) comprises lower mounting flanges (26a, 26b) for mounting to the bottom surface (27), upper mounting flanges (28a, 28b) for mounting to the PCB (2) and a through part (29) that is arranged to receive a part of the electrical component (4) that faces away from the aperture when the electrical component (4) is mounted to the PCB (2).
